# EUROPÄISCHE PATENTSCHRIFT

(11) **EP 0 299 366 B1**
(45) Veröffentlichungstag und Bekanntmachung des Hinweises auf die Patenterteilung: **20.10.1993**
(21) Anmeldenummer: 88110900.3
(22) Anmeldetag: 08.07.1988
(51) Int. Cl.: G11C 13/02, G11C 11/54

(54) **Verfahren zur Modifizierung und Adressierung organischer Filme im molekularen Bereich**
Method for the modification and addressing of organic films in the molecular field
Méthode de modification et d'adressage de films organiques dans le domaine des molécules

(30) Priorität: 16.07.1987 DE 3723540
(43) Veröffentlichungstag der Anmeldung: 18.01.1989
(73) Patentinhaber: BASF Aktiengesellschaft, 67063 Ludwigshafen (DE)
(72) Erfinder: Fuchs, Harald, Dr., D-6719 Carlsberg (DE); Schrepp, Wolfgang, Dr., D-6900 Heidelberg (DE)

(56) Entgegenhaltungen:
- EP-A- 0 178 606
- GB-A- 2 185 352
- US-A- 4 575 822
- COMPCON 1984, IEEE COMPUTER SOCIETY INTERNATIONAL CONFERENCE "INTELLECTUAL LEVERAGE THE DRIVING TECHNOLOGIES " 27. Februar 1984, SAN FRANCISCO, USA Seiten 110 - 114; F.L CARTER: 'Prospects for Computation at the Molecular Size Level '
- NEW ELECTRONICS.INCORPORATING ELECTRONICS TODAY. Bd. 16, Nr. 18, September 1983, LONDON GB Seite 6; 'Molecules May Replace Memory Chips '

## Beschreibung

Die Erfindung betrifft ein Verfahren zur Modifizierung und Adressierung organischer Filme im molekularen Bereich mittels Tunnelmikroskopie.

Die heute verfügbaren Aufzeichnungsmedien speichern Informationen vorwiegend in anorganischen Systemen. In elektronischen Schaltkreisen wird die erreichbare Speicherdichte begrenzt durch die kleinsten erzeugbaren Strukturen, in denen die Wellennatur der Elektronen noch nicht merklich die Funktion der Elemente stören kann. Ein weiteres Problem stellt dabei die mit steigender Speicherdichte rasch ansteigende Warmedichte in elektronischen Schaltkreisen dar, die schließlich zu hohen thermischen Belastungen und erhöhter Elektrodiffusionsrate bzw. Migrationsrate, z.B. von Dotierungsstoffen oder in Kontaktelektroden und zum Ausfall der Bauelemente fuhrt. Magnetische Speicher sind in ihrer Speicherdichte begrenzt durch die kleinsten magnetisierbaren Bereiche (Weiß'sche Bezirke) und technisch durch die laterale Ausdehnung des Magnetfeldes des schreibenden bzw. lesenden Magnetkopfes. Optische Speicher erlauben bereits Speicherdichten im Bereich der Lichtwellenlange und sind im wesentlichen beugungsbegrenzt, d.h. Strukturen im Bereich von 0,2 bis 0,5 µm sind technisch erzeugbar. Eine wesentliche Steigerung der Speicherdichte ist mit den genannten Methoden nach heutigem Wissens stand nicht mehr zu erreichen.

Ein Zugang zu wesentlich höheren Speicherdichten im Tera-Byte-Bereich etwa in Form von organischen, molekularen Speichern, konnte bisher nicht realisiert werden, da eine Methode zur Ansteuerung nicht bekannt war.

Die Wirksamkeit und die Funktion solcher organischer Speicher extrem hoher Dichte ist durch die erfolgreiche Nutzung in biologischen Systemen bewiesen. Technisch besteht das Problem jedoch in der Adressierbarkeit einzelner Moleküle oder Molekülverbände, z.B. in geordneten anisotropen Filmen, wie u.a. in Langmuir-Blodgett-Schichten. Bei einer benötigten Speicherfläche von 25 Å² pro Informationseinheit ergeben sich theoretische Speicherdichten in der Größenordnung von 10¹⁴ bit/cm² (10 Terabyte/cm²), d.h. auf 10 cm² wäre die Speicherkapazität des menschlichen Gehirns unterzubringen.

In der GB-A-2 185 352 ist ein dreidimensionales Tunnelspeichergerät beschrieben, welches aus mehreren, monomolekularen Schichten besteht, die in Speicherzellen abgrenzenden Bereichen elektrische Ladungen speichern können. Durch ein äußeres elektrisches Feld werden die Ladungen in einer Zeitfolge von einer Schicht zur nächsten transportiert, so daß die gespeicherte Information mittels eines Lesekreises in Form einer Ladungsfolge gelesen werden kann. Gemessen an molekularen Speicherzellen handelt es sich hier um eine planare Speicheranordnung mit um Größenordnungen niedrigeren Speicherdichten, die aus lithographischen Gründen nicht wesentlich steigerbar sind.

Aus der US-A-4 575 822 ist ein digitaler Speicher bekannt, bei dem die Oberfläche eines Substrats in mikroskopischen Bereichen irreversibel strukturell gestört wird und diese die Informationseinheiten darstellenden Störungen mittels eines Tunnelelektronenstromes detektiert werden. Auch hier geht der Speicherbereich für eine Informationseinheit wesentlich über die molekulare Größenordnung hinaus.

Es bestand daher die Aufgabe, Speichermedien für den Tera-Byte-Bereich mit Hilfe geordneter organischer Schichten bereitzustellen.

Es wurde nun gefunden, daß mit einem Verfahren zur Modifizierung und Adressierung organischer Filme im molekularen Bereich die gestellte Aufgabe gelöst werden kann, wenn bei einem Aufzeichnungsmedium, bestehend aus einem dimensionsstabilen Träger und einer darauf aufgebrachten organischen Schicht mittels der Meßelektrode eines Tunnelmikroskops einzelne, als Speicherzellen dienende Moleküle oder Molekülgruppen ausgewählt und diese mittels eines kurzen Spannungs- oder Stromimpules mit einer Kanalbreite bis herab zu 0,1 nm, der über den Tunneleffekt oder Feldeffekt erzeugt wird, in ihrer molekularen oder elektronischen Struktur verändert werden.

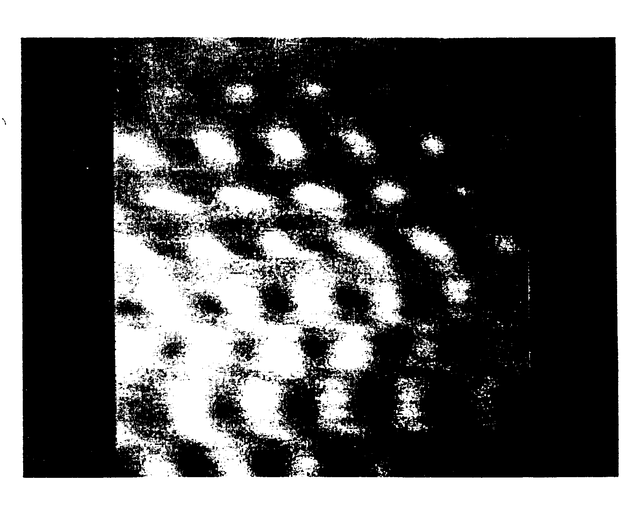

Die Tunnelmikroskopie zur Durchführung des erfindungsgemäßen Verfahrens ist bekannt (G. Binnig und H. Rohrer, "Scanning Tunneling Microscopy", Helv. Phys. Acta 55, 726 (1982)). Die hohe Abstandsempfindlichkeit des Tunnelstroms von der Meßelektrode zur Oberfläche bedingt einen extrem engen Stromkanal im atomaren Bereich. Die hohe laterale Auflösung dieses Verfahrens im Nanometerbereich erlaubt die Abbildung einzelner organischer Moleküle, z.B. einer Langmuir-Blodgett-Schicht (siehe Abbildung und auch D.P.E. Smith et al. , Proc. Nat. Acad. of Sci. USA 84 (1987) 969). Die Speicherung von Informationen erfolgt dadurch, daß durch Anlegen eines kurzen Spannungs- oder Stromimpulses einzelne Moleküle oder Molekülgruppen aus dem Molekülverband herausgelöst werden oder die Moleküle polymerisiert oder vernetzt werden oder aber depolymerisiert und/oder einzelne Moleküle durch teilweise Zerstörung der Hauptkette herausgelöst werden und in die Gasphase übergehen. Die so erzeugte Störung bzw. Oberflächenmodifikation dient als Informationseinheit. Das Auslesen der Information geschieht durch die direkte Strukturvermessung bzw. durch Messung der lokalen Variation der Potentialbarriere oder der lokalen elektronischen Zustandsdichte der Schicht aufgrund der vorausgegangenen Manipulation. Die als Informationseinheit dienende Störung läßt sich in gleich vorteilhafter Weise durch Implantation von Ionen oder Atomen, die von der spitzenartigen Meßelektrode des Tunnelmikroskops in die Schicht eingebaut werden, erzeugen. Ebenfalls läßt sich durch Injektion von Elektronen in eine solche Schicht die elektronische Eigenschaft der Schicht verändern.

Als organische Filme kommen Langmuir-Blodgett-Filme u.a. mit vernetzbaren oder polymerisierbaren Gruppen, wie z.B. ω-Tricosensäure oder Diacetylencarbonsäure oder Derivate in Frage. Es lassen sich ebenfalls hierfür geeignete geordnete organische Filme, z.B. Phthalocyanine, durch Abscheiden aus der Gasphase (H. Usui et al., J. Vac. Sci. Techn. 4 (1986), 52-56; H. Sasabe, Proc. Int. Symp. Future Electron Dev. Nov. 20/21, 1985, Tokyo) z.B. mittels PVD, CVD, MO oder MBE oder mit Siloxanen aus der Flüssigphase ("Organized Monolayers by Adsorption", Jacob Sagiv, J. Am. Chem. Soc. 102 (1980), 92-98) erhalten

Als dimensionsstabile Träger für diese Filme eignen sich Metalle, Halbmetalle, Halbleiter oder isolierende Träger, die mit einer leitfähigen Schicht versehen sind.

## Patentansprüche

1. Verfahren zur Modifizierung und Adressierung organischer Filme im molekularen Bereich, dadurch gekennzeichnet, daß bei einem Aufzeichnungsmedium, bestehend aus einem dimensionsstabilen Träger und einer darauf aufgebrachten organischen Schicht mittels der Meßelektrode eines Tunnelmikroskops einzelne, als Speicherzellen dienende Moleküle oder Molekülgruppen ausgewählt und diese mittels eines kurzen Spannungs- oder Stromimpulses mit einer Kanalbreite bis herab zu 0,1 nm, der über den Tunneleffekt oder Feldeffekt erzeugt wird, in ihrer molekularen oder elektronischen Struktur verändert werden.

## Claims

1. A process for the modification and addressing of an organic film in the molecular range, wherein, in a recording medium consisting of a dimensionally stable base and an organic film applied to the said base, individual molecules or groups of molecules serving as memory cells are selected using the measuring electrode of a tunnel microscope and their molecular or electronic structure is altered by means of a short voltage or current pulse which has a channel width down to 0.1 nm and is generated via the tunneling effect or field effect.

## Revendications

1. Procédé de modification et d'adressage de films organiques dans le domaine moléculaire, caractérisé par le fait que dans un milieu d'enregistrement constitué d'un support à stabilité dimensionnelle et d'une couche organique appliquée dessus, on sélectionne, au moyen de l'électrode de mesure d'un microscope tunnel, des molécules individuelles ou groupes de molécules servant de cellules-mémoire, et on en modifie la structure moléculaire ou électronique au moyen d'une brève impulsion de tension ou de courant d'une largeur de canal descendant jusqu'à 0,1 nm, impulsion qui est produite par l'intermédiaire de l'effet tunnel ou effet de champ.
